# EUROPEAN PATENT APPLICATION

(11) **EP 4 753 390 A1**
(43) Date of publication of application: **03.06.2026**
(21) Application number: 25219821.3
(22) Date of filing: 01.12.2025
(51) Int. Cl.: H05K 7/20, G01M 3/04

(54) **LEAK DETECTION SYSTEM INCLUDING THERMALLY-REACTIVE DRIP PAN**

(30) Priority: 02.12.2024 US 202463726973 P; 25.11.2025 US 202519400036
(71) Applicant: Vertiv Corporation, Westerville, OH 43082 (US)
(72) Inventor: KELLER, Matthew Griffith, Westerville, 43082 (US); KOLOMIIETS, Sarah Kimberly, Westerville, 43082 (US); VOIGT, Tyler William, Westerville, 43082 (US)
(74) Representative: Ambroz, Simon

(57) **Abstract**

A leak detection system for a server rack, the leak detection system is disclosed. The leak detection system includes a drip pan configured for placement under one or more liquid-cooled servers of the server rack. The server rack includes a piping system configured to convey cooling fluid through the one or more liquid cooled servers, wherein a surface of the drip pan is coated in a thermally-reactive coating. The leak detection system further includes one or more thermal imaging sensors in proximity to the drip pan, wherein the one or more thermal imaging sensors are configured to detect a change to a thermal output from the drip pan in response to contact of the cooling fluid on the thermally-reactive coating.

## Description

### BACKGROUND

### 1. Field

This disclosure is directed to server racks, and more particularly, to the detection of cooling fluid leaks in server racks.

### 2. Description of Related Art

Due to the large amount of heat generated by servers mounted therein, server racks typically include cooling systems to remove excess heat. Such cooling systems include piping that carries a cooling fluid that circulates through the rack. Many implementations include direct-to-chip cooling where piping contacts chip packaging to carry away heat from the source where much of it is generated. Since coolant systems can form leaks, leak detection systems are implemented. Such leak detection systems may rely on spot detection or cables/tapes.

### SUMMARY

A leak detection system for a server rack, the leak detection system is disclosed. The leak detection system of the present disclosure includes a drip pan configured for placement under one or more liquid-cooled servers of the server rack. The server rack includes a piping system configured to convey cooling fluid through the one or more liquid cooled servers, wherein a surface of the drip pan is coated in a thermally-reactive coating. The leak detection system further includes one or more thermal imaging sensors in proximity to the drip pan, wherein the one or more thermal imaging sensors are configured to detect a change to a thermal output from the drip pan in response to contact of the cooling fluid on the thermally-reactive coating.

### BRIEF DESCRIPTION OF THE DRAWINGS

The above and/or other aspects will become apparent and more readily appreciated from the following description of examples, taken in conjunction with the accompanying drawings, in which:
FIG. 1 is a diagram illustrating an example of a server rack having a cooling system and a leak detection system.
FIG. 2 is a perspective view of a drip pan used in a leak detection system.
FIG. 3 is a top view of a drip pan used in a leak detection system.
FIG. 4 is a drawing illustrating side views of a drip pan used in a leak detection system.
FIG. 5 is a drawing illustrating the leak detection properties of a drip pan having thermally-reactive coating.

### DETAILED DESCRIPTION

Reference will now be made in detail to examples which are illustrated in the accompanying drawings, wherein like reference numerals refer to like elements throughout. In this regard, the examples may have different forms and may not be construed as being limited to the descriptions set forth herein.

It will be understood that the terms "include," "including," "comprise," and/or "comprising," when used in this specification, specify the presence of stated features, integers, steps, operations, elements, and/or components, but do not preclude the presence or addition of one or more other features, integers, steps, operations, elements, components, and/or groups thereof.

It will be further understood that, although the terms "first," "second," "third," etc., may be used herein to describe various elements, components, regions, layers and/or sections, these elements, components, regions, layers and/or sections may not be limited by these terms. These terms are only used to distinguish one element, component, region, layer or section from another element, component, region, layer, or section.

As used herein, the term "and/or" includes any and all combinations of one or more of the associated listed items. Expressions such as "at least one of," when preceding a list of elements, modify the entire list of elements and do not modify the individual elements of the list.

Various terms are used to refer to particular system components. Different companies may refer to a component by different names - this document does not intend to distinguish between components that differ in name but not function.

Matters of these examples that are obvious to those of ordinary skill in the technical field to which these examples pertain may not be described herein in detail.

Information technology (IT) equipment, such as servers mounted in server racks, can generate a significant amount of heat. Accordingly, coolant systems are implemented to manage this heat and to keep the IT equipment operating within safe temperature limits. Coolant system may include piping that carried a refrigerant or other coolant fluid that extracts heat from the servers in the rack for expulsion downstream.

Ensuring the steady flow of coolant is thus important to the safe operation of IT equipment. However, leaks can occur and adversely impact the ability to cool the IT equipment. Accordingly, leak detection systems are employed to detect coolant leaks. Previous leak detection systems involved cables, tape, and/or spot detection. These systems may not always timely detection of coolant leaks.

The present disclosure is directed to a coolant leak detection system having a drip pan coated with a thermally-reactive coating. The drip pan may be placed under a server rack or IT equipment. Thermal imaging sensors are mounted on the drip pan. When coolant leaks and drips into the drip pan, it causes a reaction on the thermally-reactive coating, thereby creating thermal hotspots or cold spots relative to the areas of the drip. This reaction is detected by the thermal imaging sensors. A computer system coupled to the thermal imaging sensor may generate an indication of a leak based on the detection of the hot or cold spots.

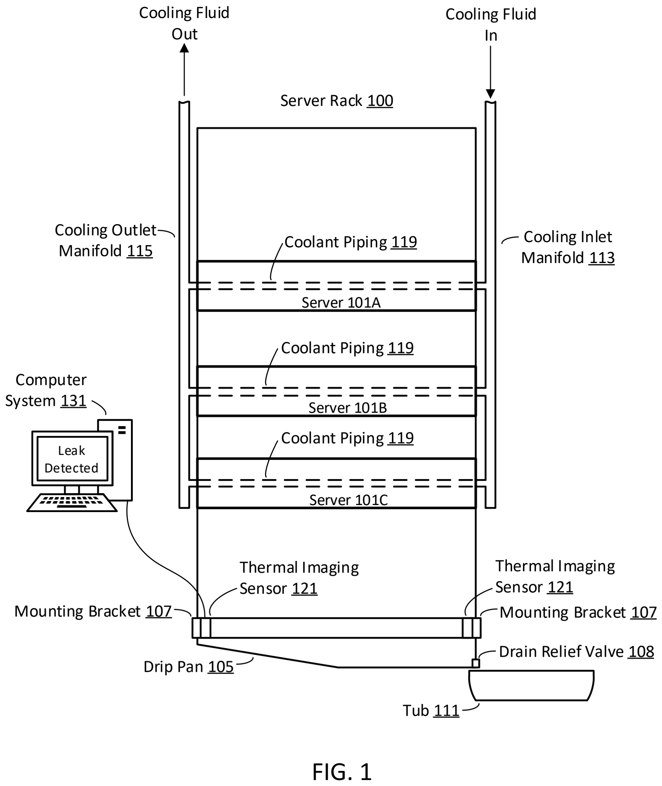

FIG. 1 is a diagram illustrating an example of a server rack having a cooling system and a leak detection system. In the example shown, server rack 100 includes three servers 100A, 100B, and 100C mounted therein. A coolant system includes a cooling inlet manifold 113, a cooling outlet manifold 115, and coolant piping extending 119 extending between the two for each of servers 100A, 100B, and 100C. Coolant fluid may be pumped into the system via cooling inlet manifold 113 by a pump (not shown), pass through the servers, via the coolant piping 119, and out via cooling outlet manifold 115. The coolant piping 119 may be coupled within each of the servers to a cold plate or other mechanism that can extract heat from components such as chips therein. Heat is transferred to the coolant in the coolant piping and carried away from the servers and server rack 100.

A drip pan 105 is mounted underneath server rack 100 via mounting brackets 107. The drip pan 105 is coated in a thermally-reactive coating that changes the temperature, and thus the thermal output, of areas that come into contact with the coolant passing through the cooling piping 119. Thermal imaging sensors 121 mounted on and are arranged to detect changes to the thermal output of drip pan 105. Indications of these changes are conveyed from the thermal imaging sensors 121 to computer system 131. Computer system 131 may utilize processing software using the information obtained from thermal imaging sensors 121 to generate an indication when a leak is detected. In some examples, the thermal imaging sensors may be augmented with motion sensing capability, with motion detection software running on computer system 131 to detect drips as the fall into drip pan 105. Alternatively, separate motion sensors may be mounted on drip pan 105 to augment the thermal sensing capability. The computer system 131 may utilize information obtained from the one or more sensors to generate an indication when leak is detected.

Drip pan 105 in the example shown includes a drain relief valve 108 to allow fluid to be drained therefrom. When opened to allow fluid drainage, drain relief valve 108 allows fluid to drain into tub 111.

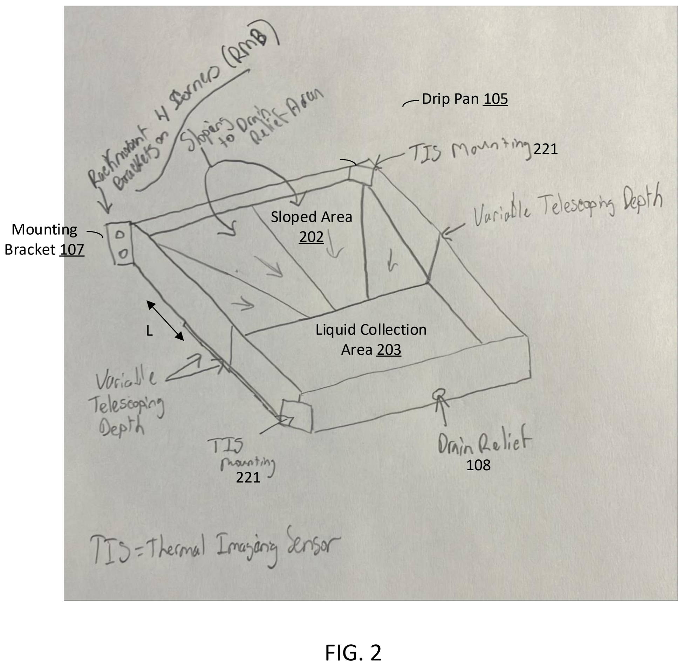

FIG. 2 is a perspective view of a drip pan used in a leak detection system. As shown here, drip pan 105 includes a sloped portion 202 and a flat liquid collection area 203. Drip pan 105 in this example is arranged to support telescoping of the sloped portion 202 with the liquid collection area 203 in order to adjust its overall length L. This in turn allows drip pan 105 to be used with racks having different dimensions along the L axis.

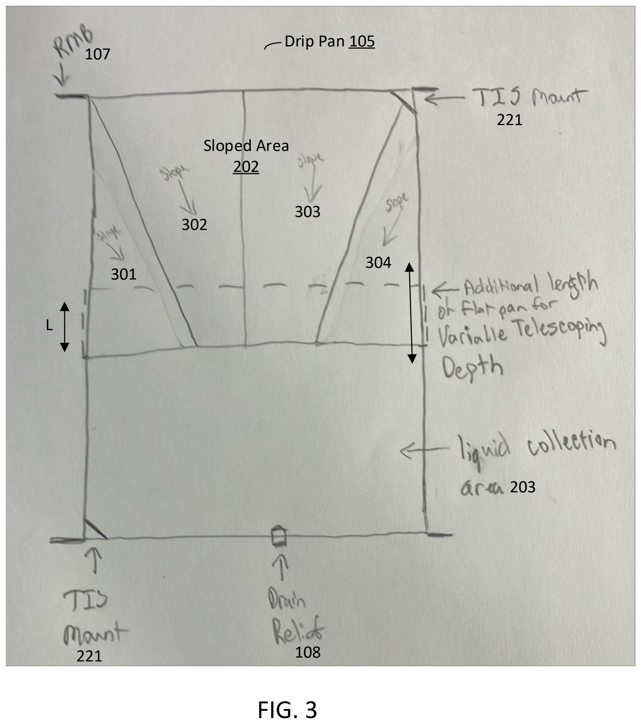

FIG. 3 is a top view of a drip pan used in a leak detection system. As shown in the drawing, the sloped area 202 is subdivided into four separate regions 301, 302, 303, and 304. Each of these sloped areas has a different orientation such that drips are directed toward the center of liquid collection area 203. Regarding the telescoping property of drip pan 105, the sloped area 202 may slide over the top of liquid collection area 203. During telescoping, the sloped area 202 may slide over the top of liquid collection area 203 such that the latter is variable in size.

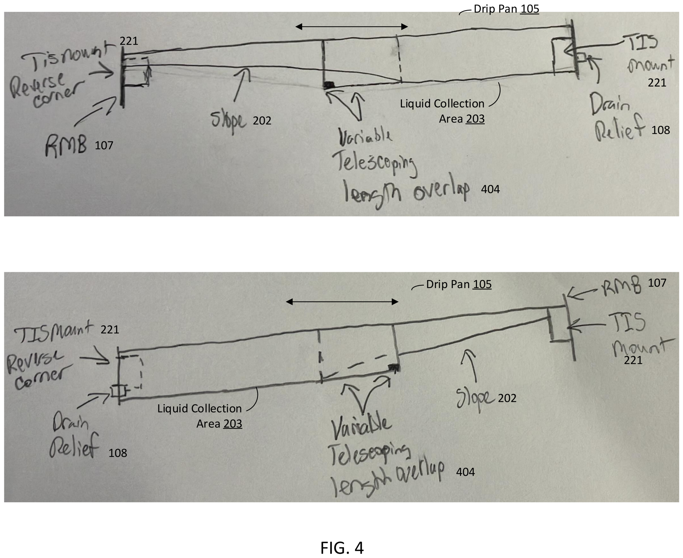

FIG. 4 is a drawing illustrating side views of a drip pan used in a leak detection system. More particularly, FIG. 4 further illustrates the telescoping property of drip pan 105 via the telescoping length overlap 404. Within this range, the length of drip pan 105 may be adjusted to fit the corresponding dimension of a particular server rack.

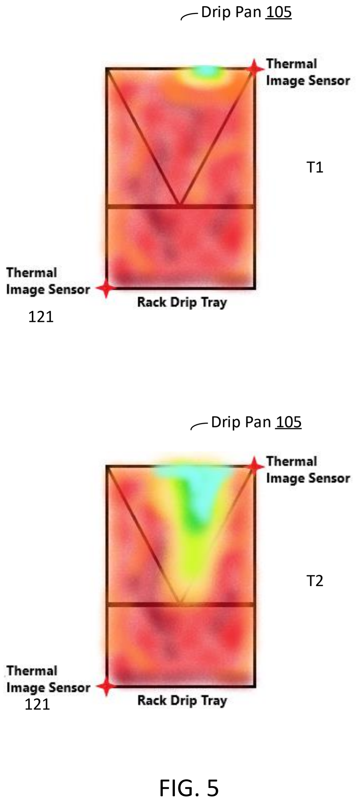

FIG. 5 is a drawing illustrating the leak detection properties of a drip pan having thermally-reactive coating. More particularly, FIG. 5 illustrates a detection of a leak enabled using the thermally-reactive coating of drip pan 105 at a first time T1, and at a later time T2. The thermally-reactive coating may comprise various compounds, such as magnesium oxide that may react with or absorb various refrigerants or cooling fluids.

In the illustrated example, at T1, a leak has formed and dripped cooling fluid on the upper periphery of drip pan 105. This results in a lower thermal output (and thus, lower temperature) at and near the portion where the cooling fluid has contacted the drip pan 105 relative to the ambient temperature of other areas on the drip pan surface. This effect is amplified by the thermally-reactive coating covering the surface of drip pan 105.

At the later time T2, additional cooling fluid has dripped into the pan, with cooling fluid flowing down the sloped portion, thereby expanding the lower thermal output/temperature area. Using the thermal imaging sensors, the change in thermal output can be detected to enable detection of the leak. In one example, the thermal imaging sensors may detect infrared radiation and variations thereof, providing indications of the same to a computer system which can generate a corresponding output indicating the presence of a coolant leak.

It may be understood that the examples described herein may be considered in a descriptive sense only and not for purposes of limitation. Descriptions of features or aspects within each example may be considered as available for other similar features or aspects in other examples.

Described herein are also the following clauses:
1. A leak detection system for a server rack, the leak detection system comprising:
   a drip pan configured for placement under one or more liquid-cooled servers of the server rack that includes a piping system configured to convey cooling fluid through the one or more liquid-cooled servers, wherein at least a portion of a surface of the drip pan is coated in a coating, wherein the coating is configured to go through a reaction in response to contact with a cooling fluid; and
   one or more sensors in proximity to the drip pan, wherein the one or more sensors are configured to detect the reaction on the drip pan in response to contact of the cooling fluid on the coating.
2. The leak detection system of clause 1, wherein the drip pan includes a telescoping mechanism for adjusting a size of the drip pan.
3. The leak detection system of any preceding clause, wherein the drip pan includes a first portion having a plurality of sloped surfaces, and a second portion including a flat surface, the second portion coupled to the first portion such that fluid from the second portion drains into the first portion.
4. The leak detection system of any preceding clause, wherein the coating is a thermally reactive coating, and wherein the reaction of the coating in response to contact with a cooling fluid changes the thermal output of the drip pan.
5. The leak detection system of any preceding clause, wherein the drip pan further comprises a drain relief valve, and wherein the leak detection system further comprises a tub arranged to receive fluid from the drip pan via the drain relief valve.
6. The leak detection system of any preceding clause, wherein the one or more sensors is a thermal imaging sensor.
7. The leak detection system of any preceding clause, further comprising a computer system coupled to the thermal imaging sensors, wherein the computer system is configured to generate an indication in response to one or more of the thermal imaging sensors detecting a leak.
8. The leak detection system of clause 7, further comprising at least one motion sensor coupled to the computer system, wherein the computer system is further configured to generate an indication of the leak in response to the at least motion sensor detecting the leak.
9. The leak detection system of any preceding clause, wherein the thermally-reactive coating comprises magnesium oxide.
10. A method for detecting a cooling fluid leak, the method comprising:
   circulating cooling fluid through a piping system coupled to a liquid-cooled server, wherein the server is mounted within a server rack;
   detecting, using one or more thermal imaging sensors, a change in thermal output of a drip pan, wherein the drip pan is mounted to the server rack and located under the piping system and is covered with a thermally-reactive coating; and
   generating, using a computer system, an indication of a leak in response to the change in thermal output of the drip pan.
11. The method of clause 10, further comprising adjusting a size of the drip pan using a telescoping mechanism.
12. The method of any one of clauses 10 to 11, wherein the drip pan includes a first portion having a plurality of sloped surfaces and a second portion including a flat surface, and wherein the method further comprises draining fluid from the second portion into the first portion.
13. The method of any one of clauses 10 to 12, further comprising draining fluid from the drip pan via a drain relief valve.
14. The method of any one of clauses 10 to 13, further comprising receiving drained fluid in a tub arranged to receive fluid from the drip pan via the drain relief valve.
15. The method of any one of clauses 10 to 14, further comprising mounting the drip pan to the server rack using mounting hardware.
16. The method of any one of clauses 10 to 14, further comprising generating the indication of the leak using a computer system coupled to the thermal imaging sensors.
17. The method of any one of clauses 10 to 16, further comprising detecting motion using at least one motion sensor coupled to the computer system, and generating the indication of the leak in response to the motion sensor detecting the leak.
18. A system comprising:
   a server rack having one or more liquid-cooled servers mounted therein, wherein the server rack includes a piping system configured to convey cooling fluid through the one or more liquid-cooled servers;
   a drip pan disposed underneath the one or more liquid-cooled servers, wherein a surface of the drip pan is coated with a thermally-reactive coating;
   one or more thermal imaging sensors in proximity to the drip pan, wherein the one or more thermal imaging sensors are configured to detect a change to a thermal output from the drip pan in response to contact of the cooling fluid on the thermally-reactive coating; and
   a computer system coupled to the thermal imaging sensors, wherein the computer system is configured to generate an indication in response to one or more of the thermal imaging sensors detecting a leak.
19. The system of clause 18, further comprising at least one motion sensor coupled to the computer system, wherein the computer system is further configured to generate an indication of the leak in response to the at least motion sensor detecting the leak.
20. The system of clause18, wherein the drip pan includes:
   a telescoping mechanism for adjusting a size of the drip pan;
   includes a first portion having a plurality of sloped surfaces, and a second portion including a flat surface, the second portion coupled to the first portion such that fluid from the second portion drains into the first portion; and
   a drain relief valve; and
   wherein the system further includes a tub arranged to receive fluid from the drip pan via the drain relief valve.

## Claims

1. A leak detection system for a server rack, the leak detection system comprising:
a drip pan configured for placement under one or more liquid-cooled servers of the server rack that includes a piping system configured to convey cooling fluid through the one or more liquid-cooled servers,
wherein at least a portion of a surface of the drip pan is coated in a coating,
wherein the coating is configured to go through a reaction in response to contact with a cooling fluid; and
one or more sensors in proximity to the drip pan, wherein the one or more sensors are configured to detect the reaction on the drip pan in response to contact of the cooling fluid on the coating.

2. The leak detection system of any preceding claim, wherein the drip pan includes a telescoping mechanism for adjusting a size of the drip pan.

3. The leak detection system of any preceding claim, wherein the drip pan includes a first portion having a plurality of sloped surfaces, and a second portion including a flat surface, the second portion coupled to the first portion such that fluid from the second portion drains into the first portion.

4. The leak detection system of any preceding claim, wherein the coating is a thermally reactive coating, and wherein the reaction of the coating in response to contact with a cooling fluid changes the thermal output of the drip pan.

5. The leak detection system of any preceding claim, wherein the drip pan further comprises a drain relief valve, and wherein the leak detection system further comprises a tub arranged to receive fluid from the drip pan via the drain relief valve.

6. The leak detection system of any preceding claim, wherein the one or more sensors is a thermal imaging sensor.

7. The leak detection system of claim 6, further comprising a computer system coupled to the thermal imaging sensors, wherein the computer system is configured to generate an indication in response to one or more of the thermal imaging sensors detecting a leak.

8. The leak detection system of claim 7, further comprising at least one motion sensor coupled to the computer system, wherein the computer system is further configured to generate an indication of the leak in response to the at least motion sensor detecting the leak.

9. The leak detection system of any preceding claim, wherein the coating comprises magnesium oxide.

10. A method for detecting a cooling fluid leak, the method comprising:
circulating cooling fluid through a piping system coupled to a liquid-cooled server, wherein the server is mounted within a server rack;
detecting, using one or more thermal imaging sensors, a change in thermal output of a drip pan, wherein the drip pan is mounted to the server rack and located under the piping system and is covered with a thermally-reactive coating; and
generating, using a computer system, an indication of a leak in response to the change in thermal output of the drip pan.

11. The method of claim 10, further comprising adjusting a size of the drip pan using a telescoping mechanism.

12. The method of any one of claims 10 to 11, wherein the drip pan includes a first portion having a plurality of sloped surfaces and a second portion including a flat surface, and wherein the method further comprises draining fluid from the second portion into the first portion.

13. The method of any one of claims 10 to 12, further comprising draining fluid from the drip pan via a drain relief valve;
and optionally further comprising receiving drained fluid in a tub arranged to receive fluid from the drip pan via the drain relief valve;
and optionally, further comprising mounting the drip pan to the server rack using mounting hardware;
and optionally, further comprising generating the indication of the leak using a computer system coupled to the thermal imaging sensors;
and optionally, further comprising detecting motion using at least one motion sensor coupled to the computer system, and generating the indication of the leak in response to the motion sensor detecting the leak.

14. A system comprising:
a server rack having one or more liquid-cooled servers mounted therein, wherein the server rack includes a piping system configured to convey cooling fluid through the one or more liquid-cooled servers;
a leak detection system according to any one of the claims 1 to 9;
a computer system coupled to the one or more sensors, wherein the computer system is configured to generate an indication in response to one or more of the sensors detecting a leak.

15. The system of claim 14, further comprising at least one motion sensor coupled to the computer system, wherein the computer system is further configured to generate an indication of the leak in response to the at least motion sensor detecting the leak;
and optionally, wherein the one or more sensors is a thermal imaging sensor.
and optionally, wherein the drip pan includes:
a telescoping mechanism for adjusting a size of the drip pan;
includes a first portion having a plurality of sloped surfaces, and a second portion including a flat surface, the second portion coupled to the first portion such that fluid from the second portion drains into the first portion; and
a drain relief valve; and
wherein the system further includes a tub arranged to receive fluid from the drip pan via the drain relief valve.
